# EUROPEAN PATENT APPLICATION

(11) **EP 2 410 574 A2**
(43) Date of publication of application: **25.01.2012**
(21) Application number: 10769991.0
(22) Date of filing: 13.05.2010
(51) Int. Cl.: H01L 31/042

(54) **METHOD FOR MANUFACTURING A SOLAR CELL**

(30) Priority: 28.04.2009 KR 20090037050
(71) Applicant: Hyundai Heavy Industries Co., Ltd., Ulsan 682-792 (KR)
(72) Inventor: MOON, In-Sik, Seongnam-si Gyeonggi-do 463-772 (KR); CHO, Eun-Chel, Yongin-si Gyeonggi-do 448-785 (KR); LEE, Won-Jae, Seongnam-si Gyeonggi-do 463-901 (KR)
(74) Representative: Robertson, James Alexander
(86) International application number: PCT/KR2010/003028
(87) International publication number: WO 2010/126346

(57) **Abstract**

The present invention provides a method for manufacturing a solar cell. The method for manufacturing a solar cell comprises: forming via holes in a silicon wafer; forming a shallow emitter on the front surface and the rear surface of the wafer, connecting the inner walls of the via holes and the via holes: and selectively forming an emitter through the heavy doping of a dopant to provide a plurality of regions along a direction linking the via holes of the shallow emitter with a certain concentration or higher. Accordingly, the present invention can selectively form an emitter on an MWT solar cell by performing laser doping or etching on a region contacting a front surface electrode having a certain width and height.

## Description

### [Technical Field]

The present invention relates a method for manufacturing a solar cell, and more particularly, to a method for manufacturing a solar cell capable of forming a selective emitter on an MWT solar cell by performing laser doping or etching on a region contacting a front surface electrode having a certain width and height.

### [Background Art]

In recent years, people have grown more and more interested in alternative energies as existing energy resources such as petroleum and coal are expected to be exhausted in the near future. Among alternative energy resources, solar cells are especially being highlighted due to their abundant energy resources and recent environmental issues. Solar cells include solar thermal cells adapted to generate vapor necessary for rotating turbines using solar thermal power, and photovoltaic cells adapted to convert photons into electric energy using the properties of semiconductors. Solar cells generally refer to photovoltaic cells (hereinafter, solar cells)

A conventional solar cell has such a structure as a diode in which a p-type semiconductor 101 and an n-type semiconductor 102 are bonded. If light enters the solar cell, electrons having negative charges and holes having positive charges are generated by interactions between light and the semiconductors of the solar cell such that electric currents flow while the electrons and the holes are moving. This phenomenon is called a photovoltaic effect in which the electrons are pulled toward the n-type semiconductor and the holes are pulled toward the p-type semiconductor such that the electrons and the holes are moved to the electrodes bonded to the n-type semiconductor and the p-type semiconductor respectively, and thus if the electrodes are connected by a wire, electric currents flow through the wire.

Among solar cells, a back-contact silicon solar cell has several advantages as compared with a conventional silicon solar cell having contacts on its front surface and rear surface. The first advantage is that it has improved conversion efficiency due to reduced and removed contact shading obscuration losses (the sunlight reflected from contact grids cannot be converted into electricity). The second advantage is that back-contact cells can be assembled in an electric circuit more easily to lower costs because opposite polar contacts exist on the same surface. For example, costs can be saved as compared with assembly of the current photovoltaic modules because a solar cell electric circuit and a photovoltaic module can be encapsulated in a single step to be achieved together with a back-contact cell.

There are several methods of manufacturing back-contact silicon solar cells. Such methods include metallization wrap around (MWA), metallization wrap through (MWT), emitter wrap through (EWT), and back junction structures.

The MWA and MWT have current collection grids on the front surfaces thereof. The grids are wrapped around their edges or are wrapped to their rear surfaces through holes to form back-contact cells respectively.

In the MWT, holes are drilled and textured to form an emitter by forming and heavily doping phosphorus silicate glass (PSG). However, in such a case, when a fine line finger having a certain width and height or less is formed on the front surface of the wafer, a selective emitter corresponding thereto cannot be formed.

### [Disclosure]

### [Technical Problem]

Therefore, it is an object of the present invention to provide a method for manufacturing a solar cell capable of forming a selective emitter on an MWT solar cell by performing laser doping or etching on a region contacting a front surface electrode having a certain width and height.

It is another object of the present invention to provide a method for manufacturing a solar cell capable of lowering power consumption by reducing contact resistance with a front surface electrode which is a fine line finger having a fine width and height.

### [Technical Solution]

In order to achieve the above-mentioned objects, there is provided a method for manufacturing a solar cell, including: forming via holes in a silicon wafer; forming a shallow emitter on inner walls of the via holes and a front surface and a rear surface of the wafer; forming a selective emitter in a plurality of regions of the shallow emitter along a direction of linking the via holes by heavily doping a dopant such that the selective emitter has a certain density or higher.

Preferably, in the heavy doping process, the selective emitter may be formed by forming phosphorus silicate glass (PSG) on the front surface of the wafer and annealing the phosphorus silicate glass (PSG) using laser.

Preferably, in the heavy doping process, the selective emitter may be formed by forming a heavy emitter layer on the front surface of the wafer, masking a plurality of regions along a direction linking the via holes, and etching back external portions of the masked regions.

Preferably, in the heavy doping process, the selective emitter may be formed by coating paste containing phosphorus (P) on the front surface of the wafer, by forming a heavy emitter layer by heat treatment at a high temperature, and by forming a shallow emitter.

Preferably, after the selective emitter is formed, silver (Ag) paste may be printed on a heavily doped portion of the front surface of the wafer and aluminum (Al) may be printed on the rear surface of the wafer.

Preferably, when the silver (Ag) paste is printed on the heavily doped portion of the front surface of the wafer, a fine line finger may be formed so as to be connected to the via holes along a direction of linking the via holes to minimize reflection of light and is plated.

Preferably, after the shallow emitter is formed, aluminum (Al) may convert the shallow emitter layer to a p-type doping layer by forming the shallow emitter layer, printing the aluminum (Al) on the shallow emitter layer, and heat-treating the aluminum (Al).

### [Advantageous Effects]

According to the present invention, conversion efficiency can be enhanced by laser-doping or etching a region of an MWT solar cell which contacts a front surface electrode having a certain width and height to form a selective emitter and reducing recombination of an emitter layer and an emitter surface.

Further, power consumption can be lowered by reducing contact resistance with a front surface electrode which is a fine line finger having a fine width and height.

### [Description of Drawings]

FIGS. 1 to 5 are sectional views illustrating a method for manufacturing a solar cell according to the present invention;
FIG. 6 is a partial sectional view illustrating a solar cell manufactured through the method for manufacturing a solar cell according to the present invention;
FIG. 7 is a top view illustrating a solar cell having a general fine line finger; and
FIG. 8 is a top view illustrating a solar cell having a fine line finger according to the present invention.

### [Best Mode]

Hereinafter, a method for manufacturing a solar cell according to the present invention will be described in detail with reference to the accompanying drawings.

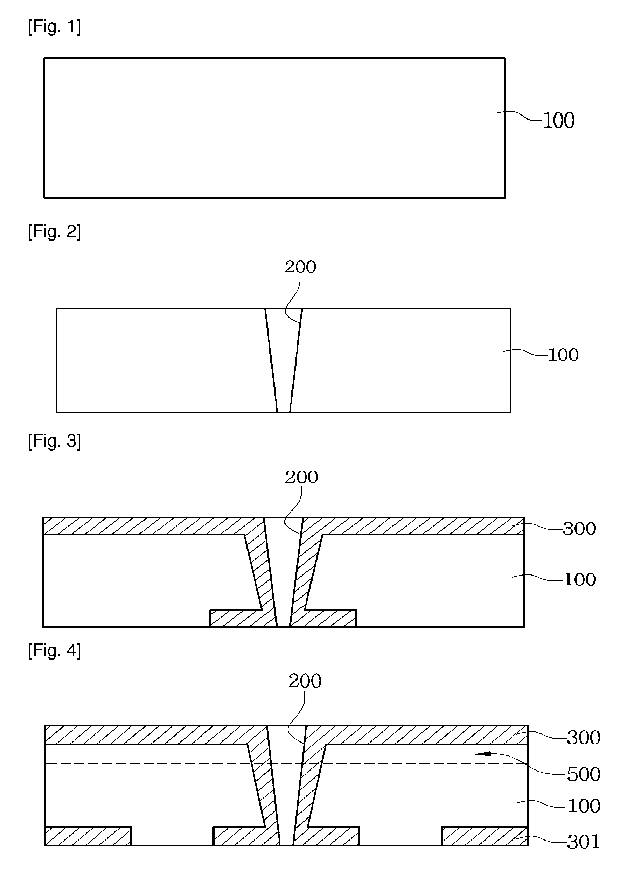

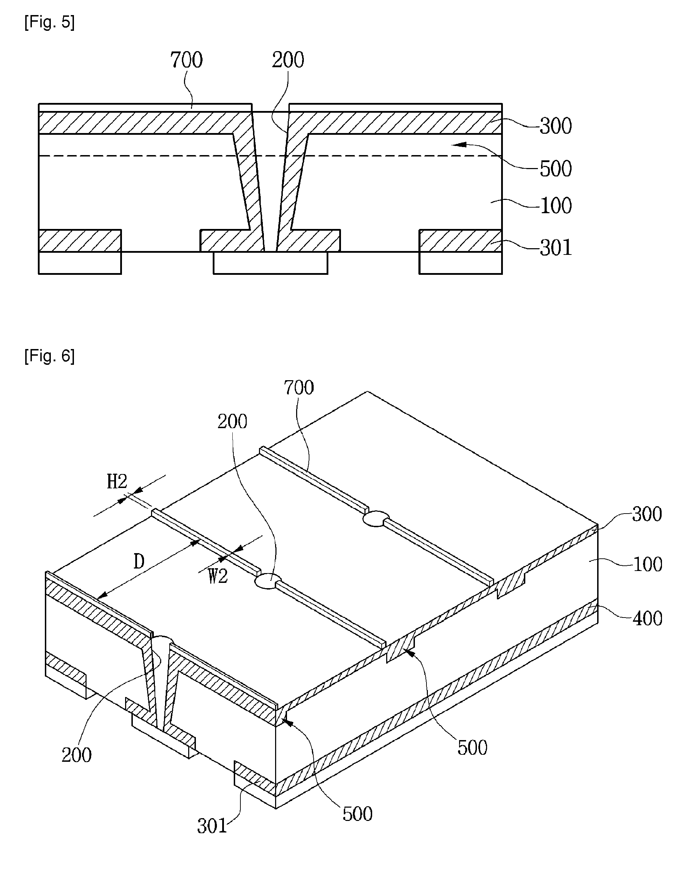

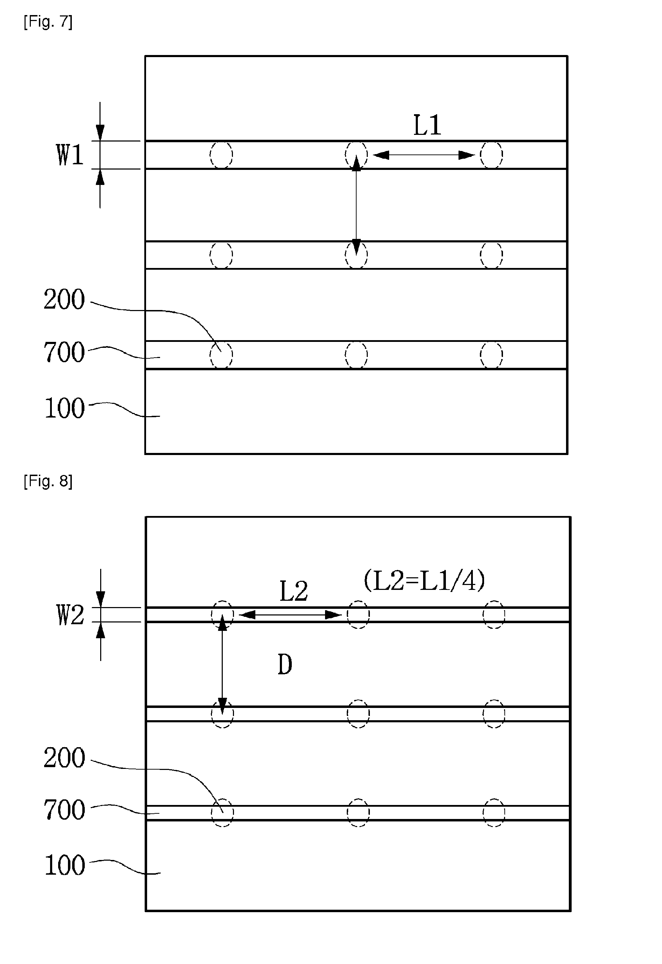

FIGS. 1 to 5 are sectional views illustrating a method for manufacturing a solar cell according to the present invention. FIG. 6 is a partial sectional view illustrating a solar cell manufactured through the method for manufacturing a solar cell according to the present invention. FIG. 7 is a top view illustrating a solar cell having a general fine line finger. FIG. 8 is a top view illustrating a solar cell having a fine line finger according to the present invention.

Referring now to FIGS. 1 and 2, via holes 200 are formed in a wafer 100. Here, the via holes 2 are formed so as to pass through the front surface and the rear surface of a prepared silicon wafer 100 using a laser. In this case, the diameter of the via holes 200 may become gradually smaller as it goes from the front surface to the rear surface of the wafer 100.

The wafer 100 having the via holes 200 is etched and cleaned. In this case, the etching step includes alkali etching or acid etching and the front surface of the wafer 100 is textured to improve absorption.

Referring further to FIG. 3, first n-type contact holes contacting the via holes 200 are formed on the rear surface of the wafer 100.

Then, a shallow emitter 300 is formed on the inner walls of the via holes 200 and the front surface and the rear surface of the wafer 100 linking the via holes 200.

Thus, the shallow emitter 300 with a low density is formed on the front surface of the wafer 100, the rear surface of the wafer 100, and the inner walls of the via holes 200.

The reference numeral '301' designates a shallow emitter layer in FIGS. 4 and 6. Then, an emitter doping layer is compensated by aluminum (Al) to be converted into a p-type doping layer in the process of printing and heat-treating Al. Here, the compensation is a process of doping Al (a p-type dopant) with a concentration higher than that of an emitter (of an n-type) to convert the emitter doping layer into a p-type doping layer.

Thereafter, a selective emitter 500 is formed in a plurality of regions of the shallow emitter 300 along a direction of linking the via holes 200 by heavily doping a dopant so as to have a certain density or higher.

The heavy doping of the present invention may follow one of two methods, i.e. a laser doping method and an etch back method.

In the former method, phosphorus silicate glass (PSG) may be formed on the front surface of the wafer 100 by heavy doping and may be annealed using a laser to form the selective emitter 500. In this case, it is preferable that the location of the selective emitter 50 with a high density is a region where an electrode or the following fine line finger 700 is provided.

In the latter method, PSG with a high density may be formed on the front surface of the wafer 100 by heavy doping and a plurality of regions along a direction linking the via holes 200 may be masked to form the selective emitter 500 after external portions of the masked regions are etched back.

Here, an alternative method is a doping paste method. According to the method, doping paste containing phosphorus (P) is coated on the wafer 100 and the P contained in the doping paste is doped by heat treatment at a high temperature to form a heavy emitter. Then, the selective emitter 500 is formed by performing a shallow emitter process. The coating of the paste is performed by screen printing, ink-jet printing, etc. It is preferable that a tube type furnace is used in a heat treating process at a high temperature and heavy doping and shallow doping are sequentially performed in a single process.

After the selective emitter 500 is formed by one of the two methods, etching is performed to remove the PSG left due to diffusion. Here, the etchant may include an aqueous HF chemical etchant, an HF dry etchant, or a plasma etchant.

A silicon nitride layer is deposited on the front surface of the wafer 100 to form a reflection preventing coating. In this case, the silicon nitride layer is deposited by plasma chemical vapor deposition (PCVD).

Then, silver (Ag) is printed on the front surface of the wafer 100 and Al is printed on the rear surface of the wafer 100.

After a metal forming process, a solar cell test process is performed.

### [Mode for Invention]

Meanwhile, referring to FIGS. 6, the shallow emitter 300 is formed first, and after the selective emitter 500 is formed by heavy doping, the PSG left due to diffusion is removed. Then, the silicon nitride layer is deposited on the front and rear surfaces of the wafer 100 using chemical vapor deposition (CVD) and Al is printed on the rear surface of the wafer 100.

Then, Ag is printed on the rear surface of the wafer 100. In this case, the fine line finger 700 is formed so as to be connected to the via holes 200 along a direction of linking the via holes 200.

Plating is performed during a metal forming process to perform a solar cell test process.

Referring to FIGS. 7 and 8, the height H2, width W2, and the cross-sectional area of the fine line finger 700 are 9 µm, 60 µm, and 270 µm² respectively.

When compared to the general fine line finger 700 of FIG. 7 with the assumption that the height H1, width W1, and the cross-sectional area of the general fine line finger 700 are 18 µm, 120 µm, and 1080 µm² respectively, its material of the general fine line finger 700 is the same as that of the fine line finger 700, and its density and current density are constant, it can be seen that the shading loss % is 2.6% for the fine line finger 700 according to the present invention and 5.2% for the general fine line finger 700. Here, the distance between the fine line fingers is 2.3 mm.

## Claims

1. A method for manufacturing a solar cell, comprising:
forming via holes in a silicon wafer;
forming a shallow emitter on inner walls of the via holes and a front surface and a rear surface of the wafer;
forming a selective emitter in a plurality of regions of the shallow emitter along a direction of linking the via holes by heavily doping a dopant such that the selective emitter has a certain density or higher.

2. The method as claimed in claim 1, wherein, in the heavy doping process, the selective emitter is formed by forming phosphorus silicate glass (PSG) on the front surface of the wafer and annealing the PSG using a laser.

3. The method as claimed in claim 1, wherein, in the heavy doping process, the selective emitter is formed by forming a heavy emitter layer on the front surface of the wafer, masking a plurality of regions along a direction linking the via holes, and etching back external portions of the masked regions.

4. The method as claimed in claim 1, wherein, in the heavy doping process, the selective emitter is formed by coating paste containing phosphorus (P) on the front surface of the wafer, forming a heavy emitter layer by heat treatment at a high temperature, and forming a shallow emitter.

5. The method as claimed in claim 1, wherein, after the selective emitter is formed, silver (Ag) paste is printed on a heavily doped portion of the front surface of the wafer and aluminum (Al) is printed on the rear surface of the wafer.

6. The method as claimed in claim 5, wherein, when the Ag paste is printed on the heavily doped portion of the front surface of the wafer, a fine line finger is formed so as to be connected to the via holes along a direction of linking the via holes to minimize reflection of light and is plated.

7. The method as claimed in Claim 5, wherein, after the shallow emitter is formed, Al converts the shallow emitter layer into a p-type doping layer by forming the shallow emitter layer, printing the Al on the shallow emitter layer, and heat-treating the Al.
